**Europäisches Patentamt**

**European Patent Office**

**Office européen des brevets**

(19)

(11) Veröffentlichungsnummer : **0 564 431 B1**

(12) # EUROPÄISCHE PATENTSCHRIFT

(45) Veröffentlichungstag der Patentschrift :
01.02.95 Patentblatt 95/05

(51) Int. Cl.⁶ : **H01S 3/133, G01B 9/02**

(21) Anmeldenummer : **93890026.3**

(22) Anmeldetag : **25.02.93**

(54) **Anordnung zur Stabilisierung der Wellenlänge des von einer Laserdiode abgegebenen Lichstrahles und Laser-Interferometer.**

(30) Priorität : **02.04.92 AT 677/92**

(43) Veröffentlichungstag der Anmeldung :
**06.10.93 Patentblatt 93/40**

(45) Bekanntmachung des Hinweises auf die Patenterteilung :
**01.02.95 Patentblatt 95/05**

(84) Benannte Vertragsstaaten :
**BE CH DE FR GB IT LI LU NL SE**

(56) Entgegenhaltungen :
**WO-A-90/12279**
**DE-A- 3 930 273**

(73) Patentinhaber : **RSF-Elektronik Gesellschaft m.b.H.**
**A-5121 Tarsdorf 93 (AT)**

(72) Erfinder : **Rieder, Heinz**
**Maria Bühelstrasse 23**
**A-5110 Oberndorf (AT)**
Erfinder : **Schwaiger, Max**
**Weilhartstrasse 13**
**A-5121 Ostermiething (AT)**

(74) Vertreter : **Hübscher, Heiner, Dipl.-Ing. et al**
**Spittelwiese 7**
**A-4020 Linz (AT)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Anordnung zur Stabilisierung der Wellenlänge des von einer Laserdiode abgegebenen Lichtstrahles, gemäß dem Oberbegriff des Patentanspruches 1.

Ferner betrifft die Erfindung ein Laser-Interferometer gemäß dem Oberbegriff des Patentanspruches 7.

Eine Stabilisierung der Wellenlänge des abgegebenen Lichtstrahles ist für eine Vielzahl von Anwendungsfällen von Interesse. Als Beispiel sei hier die Informationsübertragung über Lichtwellenleiter angeführt. In der Folge werden die Probleme aber in erster Linie im Zusammenhang mit einem Interferometer behandelt.

Die Verwendung von Laserdioden bei Laser-Interferometern ist bisher auf Sonderausführungen eingeschränkt. Aus der DE-A-39 11 473 ist eine Stabilisierungseinrichtung der eingangs genannten Art bei der Laserdiode eines Laser-Interferometers bekannt. Dabei wird das von der Laserdiode abgegebene Licht in mehrere Teilstrahlen aufgeteilt, die über gesonderte monomode Lichtleitfasern geführt werden.

Eine dieser Fasern führt zu einem Objektiv, von dem der Meßstrahl über die Meßstrecke gleitet wird. Eine zweite Faser leitet einen Referenzlichtstrahl zu einer Empfangseinrichtung, der auch der über ein verstellbares Meßprisma umgelenkte und über ein Objektiv erfaßte Meßstrahl über eine weitere Faser zugeführt und dort mit dem Referenzstrahl zur Interferenz gebracht wird.

Für die Wellenlängenstabilisierung werden zwei weitere Teillichtstrahlen über gleichlange Lichtleitfasern ausgekoppelt und einer zusätzlichen Interferenzeinrichtung zugeführt, wo sie zur Interferenz gebracht werden. Dabei werden die Austrittsöffnungen dieser Lichtleitfasern nebeneinander angebracht, so daß das austretende Licht interferieren kann und auf im Abstand von den Austrittsöffnungen angeordneten Photodioden Signale erzeugt, deren Intensität sich in Abhängigkeit von der Wellenlänge ändert. Es ist sowohl für die Messung als auch für die Wellenlängenstabilisierung die Einstellung eines konstanten Abstandes zwischen den Lichtaustrittsöffnungen und den Photoempfängern notwendig.

Aus der DE-A-39 30 273 ist es bekannt, bei einem Laser-Interferometer einen Festkörper-Laser zu verwenden, der durch wenigstens eine Laserdiode angeregt wird, wobei das im Infrarotbereich emittierte Licht der Laserdioden im Festkörper-Laser in eine andere Wellenlänge umgewandelt wird und sich über den Festkörper-Laser (z. B. Neodym-Festkörper-Laser) eine Stabilisierung des Strahls und der Wellenlänge erzielen läßt. Zur Stabilisierung der Wellenlänge wird hier ein eigenes Meß-Interferometer verwendet, dem ein aus dem Meßstrahl ausgekoppelter Teilstrahl zugeführt wird, wobei Änderungen der Wellenlänge entsprechende Hell-Dunkelübergänge im Meß-Interferometer erzeugen, die für die Regelung ausnützbar sind. Bei dieser Regelung wird entweder der Betriebsstrom der anregenden Laserdioden verändert oder es wird am Feststoff-Laser die Steuerung der Resonatorflächen variiert.

Wie oben schon ausgeführt wurde, hängt bei interferometischen Längenmessungen die Genauigkeit des Meßergebnisses entscheidend von der Kenntnis und der Konstanthaltung der Wellenlänge des verwendeten Laserlichtes ab. Bei Einfrequenz-Lasern wird die bei Verstellung des Meßreflektors durch Interferenz des Referenzstrahles mit dem Meßstrahl auftretende Anzahl von Hell-Dunkelwechseln gezählt und es gilt: $\Delta l = m^{\lambda}/2$. Dabei bedeutet $\Delta l$ die Wegänderung, m die Zahl der Hell-Dunkelwechsel und $\lambda$ die Wellenlänge des Lasers.

Die Intensität des von den Photoempfangseinrichtungen empfangenen Lichtes ändert sich sinusförmig. Die Auflösung kann durch entsprechende Schaltungen vergrößert werden.

Die Wellenlänge hängt ab von der Frequenz der Laserlichtquelle und dem Brechungsindex des Mediums, in dem sich das Licht fortbewegt. Es gilt: $\lambda = \dfrac{C}{f}$ bzw. $C = \dfrac{C_o}{n}$, wobei

C die Lichtgeschwindigkeit in einem Medium,
$C_o$ die Vakuumlichtgeschwindigkeit und
n der Brechungsindex sind. n hängt unter anderem von der Temperatur T, der Luftfeuchtigkeit, dem Luftdruck p und der Luftzusammensetzung ab, wobei eine Berechnung von n nach der sogenannten Edlen-Formel möglich ist.

Handelsübliche Interferometer verwenden stabile Laserlichtquellen, wie Zeeman-stabilisierte He-Ne-Laser. Bei der Messung werden die Luftparameter einzeln oder über sogenannte Wavelengthtracker in Summe erfaßt, wobei bei stabilisierten Laserlichtquellen die Frequenz und damit die Wellenlänge nicht verändert bzw. nicht mit brauchbaren Regeleinrichtungen nachgeregelt werden können, sondern das jeweilige Meßergebnis in Rechnern mit entsprechenden Korrekturwerten beaufschlagt wird.

Im Gegensatz zu den stabilisierten He-Ne-Lasern ist bei Laserdioden eine bisher sogar vielfach unerwünschte Frequenzänderung durch verschiedene Betriebsparameter möglich. Die Frequenz und damit die Wellenlänge ändern sich insbesondere in Abhängigkeit von der Temperatur als auch in Abhängigkeit vom Betriebsstrom der Laserdiode. Für eine handelsübliche unter der Bezeichnung "HL7801 E" erhältliche Laserdiode gilt z. B.

EP 0 564 431 B1

$$\frac{\Delta\lambda}{\Delta T} = 0{,}06 \text{ nm/°C und } \frac{\Delta\lambda}{\Delta I} = 0{,}006 \text{ nm/mA}$$

Weiterhin kann sich die Frequenz mit der Alterung der jeweiligen Laserdiode ändern. Eine Verwendung der bei stabilisierten Lasern bekannten Einrichtungen zur Korrektur des Meßergebnisses wäre zu aufwendig und ungenau. Es wird deshalb bei Laserdioden versucht, die Wellenlänge durch Regelung des Betriebsstromes der Laserdiode zu stabilisieren, wobei wieder die Umwelt- und Betriebsparameter über gesonderte Meßeinrichtungen erfaßt und ein Regelkreis für den Betriebsstrom der Laserdiode entsprechend gesteuert wird.

Aufgabe der Erfindung ist die Schaffung einer Anordnung nach dem Oberbegriff des Patentanspruches 1, bei der die Wellenlänge der Laserdiode mit einfachen Mitteln stabilisiert werden kann. Die Erfindung soll außerdem die Schaffung eines Laserinterferometers ermöglichen, das unter Ausnützung der Stabilisierung der Wellenlänge durch die geschaffene Anordnung eine Verbesserung der Auswertung der Meßergebnisse bei Erhöhung der Auflösung unter Verwendung einfacher Endauswerteeinheiten ermöglicht.

Die gestellte Aufgabe wird durch die Merkmale des Patentanspruches 1 gelöst.

Lage und/oder Größe des Licht- (Brenn-)fleckes hängen nach der Beugung und Fokussierung des Meß-Teilstrahles von der Wellenlänge im Übertragungsmedium ab, die bei ordnungsgemäßen Messungen der Wellenlänge in der Meßstrecke entspricht. Durch die vorgesehene Fokussierung wird eine hohe Trennschärfe erzielt, so daß schon kleine Abweichungen in der Wellenlänge für die Erzeugung brauchbarer Steuersignale und damit für die Rückkopplung verwendet werden können und die Wellenlänge tatsächlich in ganz engen Grenzen stabilisierbar wird. Konstruktiv sind im Rahmen der Erfindung verschiedene Varianten möglich.

Eine besonders einfache Ausführung ist im Anspruch 2 angegeben. Dabei kann das Ausgangssignal der Photoempfänger unmittelbar für die Stromregelung der Laserdiode verwendet werden.

Das Beugungsgitter kann gemäß Anspruch 3 als Echelettegitter (Gitter mit im Längsschnitt sägezahnförmigen Gitterelementen) ausgeführt sein. Bei einer Weiterbildung nach Anspruch 4 wird keine eigene Fokussierungsoptik benötigt.

Bei einer Ausbildung nach Anspruch 5 können die Photodioden in Gegenschaltung verbunden sein, so daß über das Summierglied sowohl eine Erhöhung als auch eine Verringerung des Betriebsstromes gegenüber der durch die Konstantstromquelle bestimmten Nennstromstärke möglich ist. Um Schwingungserscheinungen bei der Regelung zu vermeiden, kann die Verstärkerschaltung gemäß Anspruch 6 ausgeführt sein.

Nach Stabilisierung der Wellenlänge durch die erfindungsgemäße Anordnung wird es ebenfalls erfindungsgemäß möglich, eine weitere Eigenschaft von Laserdioden für eine neue Konzeption eines Laserinterferometers auszunützen. Diese besondere Eigenschaft von Laserdioden besteht darin, daß sie weitgehend linear polarisiertes Licht abstrahlen.

Ein derartiges erfindungsgemäßes Laserinterferometer ist in Anpsurch 7 angegeben.

Bei dieser Anordnung eilt auch abhängig von der Verstellrichtung des Meßreflektors der eine oder andere Signalzug dem anderen vor, so daß aus der Erfassung der Meßsignalzüge auch die Verstellrichtung des Meßreflektors eindeutig definiert ist. In weiterer Folge können aus den Signalzügen binäre Zählsignale für Zählschaltungen abgeleitet werden, die an sich bei inkrementalen Meßsystemen herkömmlicher Bauart bekannt und üblich sind. Man kann sogar das Auflösungsvermögen durch an sich bekannte Vervielfacherschaltungen, Interpolationsrechner usw. vergrößern. Der entscheidende Vorteil besteht aber in der Möglichkeit, übliche Auswertungseinrichtungen in geringfügig modifizierter Form einsetzen zu können. Bei der gekennzeichneten Ausbildung des Interferometers wird in Anlehnung an die Standardbauweise von Laserinterferometern eine rechtwinkelige Ausblendung des Referenzstrahles aus dem Arbeitsstrahl und der Richtung des Arbeitsstrahles folgender Verlauf des Meßstrahles gewählt. Es wären prinzipiell auch Konstruktionen möglich, bei denen andere Ablenkwinkel vorhanden sind. Hier wäre die Neigung der Polarisationsebene des Arbeitsstrahles und die Relativlage der Reflektoren, Strahlteiler usw. entsprechend zu modifizieren.

Konstruktiv ergibt sich eine einfache Ausführung gemäß Anspruch 8. Die "ordentliche bzw. außerordentliche" Achse von λ/4-Platten ist auch als schnelle und langsame Achse bekannt.

Gemäß Anspruch 9 ist der Strahlteiler zugleich als die reflektierten Strahlen ausblendender Reflektor ausgebildet, wobei man eine gemeinsame nachgeordnete oder auch gesonderte, im Strahlengang der reflektierten Strahlen vorgeordnete λ/4-Platten für die beiden reflektierten Strahlen vorsehen kann.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen

Fig. 1      in stark schematisierter Darstellungsweise und teilweiser Blockdarstellung ein Laserinterferometer in Draufsicht,

Fig. 2      zur Erläuterung der Wirkungsweise der Stabilisierungsanordnung die Fokussierungseinrichtung für den Teilstrahl mit zwei Photoempfängern und

Fig. 3      ein Blockschaltschema der Versorgungseinrichtung der Laserdiode.

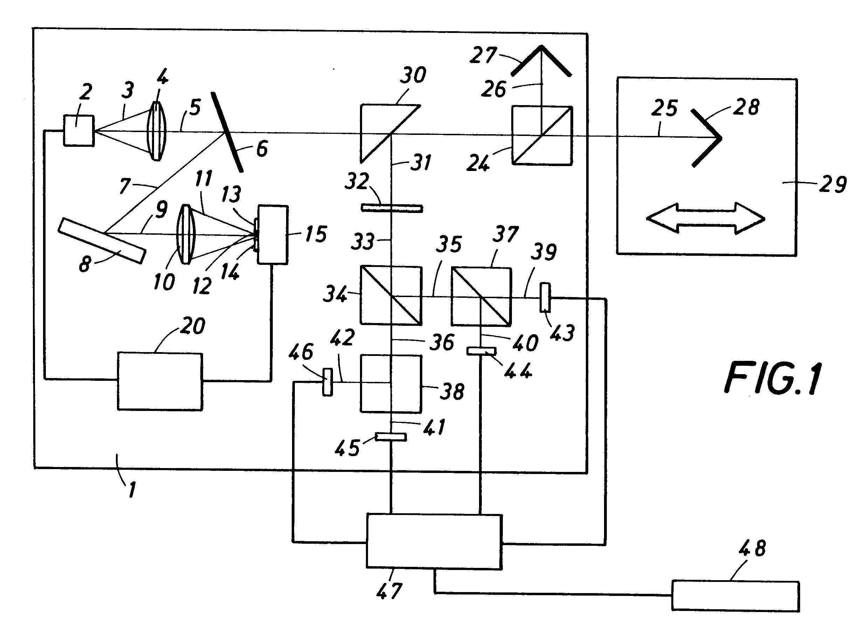

Nach Fig. 1 sind alle wesentlichen Elemente eines Einfrequenz-Laserinterferometers mit Ausnahme des Meßreflektors auf einer gemeinsamen Grundplatte 1 angeordnet, die aus einem Material mit ganz geringer Wärmedehnungszahl, z. B. Invar^R besteht. Eine Laserdiode 2 gibt ein divergentes Lichtbündel 3 ab, das von einem Objektiv 4 parallelgerichtet wird und als Arbeitsstrahl 5 abgegeben wird. Dieses licht ist polarisiert und die Laserdiode 2 wird so eingestellt, daß die Polarisationsebene des Lichtes im Arbeitsstrahl 5 zur Horizontalen und auch zur Abstrahlrichtung eines noch zu beschreibenden Strahlteilers unter 45° geneigt ist. Zunächst wird die Einrichtung zur Stabilisierung der Wellenlänge beschrieben. Für diese ist ein zusätzlicher Strahlteiler 6 vorhanden, der aus dem weiterführenden Arbeitsstrahl einen Teilstrahl 7 ausblendet und zu einem Phasengitter 8 leitet, auf dem der Strahl gebeugt wird, wobei die Beugungsrichtung des abgegebenen Lichtes 9 von der Wellenlänge abhängt. Das gebeugte Licht tritt durch eine Sammellinse 10 oder sonstige Sammeloptik und wird von dieser fokussiert. Die Taille des fokussierten Strahlteiles 11 ist bei der der Nennwellenlänge entsprechenden Frequenz der Laserdiode 2 auf einen Spalt 12 zwischen zwei Photodioden 13, 14 gerichtet. Ändert sich die Wellenlänge, so wandert der Lichtfleck um einen Betrag

$$\Delta z \;=\; \frac{f x \Delta\lambda}{\cos \beta \; x \; g}\;.$$

Dabei bedeuten:
f die Brennweite des Objektives 10,
$\Delta\lambda$ die Wellenlängenänderung,
$\beta$ den Beugungswinkel und
g die Gitterkonstante.
Rechnerisch ergibt sich hier für f = 60 mm $\beta$ = 70° und
g = 0,5 $\mu$m bei einer Wellenlängenänderung von 0,008 nm
eine Änderung $\Delta$ z von 0,28 $\mu$m. Dies entspricht bei einer Wellenlänge $\lambda$ von 800 nm einer Abweichung des Meßergebnisses von etwa 1 ppm. Aus diesen Werten ergibt sich auch, weshalb ein steifer und kompakter Aufbau und eine Platte 1 aus einem Material mit sehr geringem Wärmedehnungskoeffizienten z. B. aus Zerodur^R oder Invar^R gewählt werden.

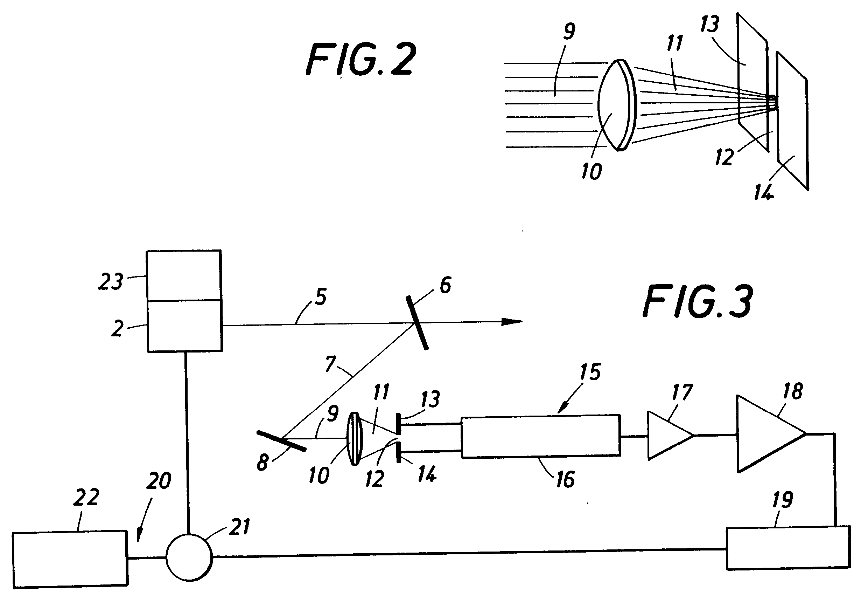

Aus den Signalen der beiden Dioden 13, 14, die auch als Doppeldiode ausgeführt sein können, wird ein Differenzsignal gebildet und in einer Auswertungsschaltung 15 weiterverarbeitet, die nach Fig. 3 einen Stromspannungswandler 16, einen Vorverstärker 17 und einen Integrierer 18 sowie einen Spannungsstromwandler 19 umfaßt, wobei der Integrierer durch Verwendung eines Operationsverstärkers auch die Funktion eines Tiefpaßfilters erfüllt. Das Ausgangssignal der Auswertungsschaltung 15 wird einer Versorgungseinheit 20 für die Laserdiode 2 zugeführt, die nach Fig. 3 einen Summenbildner 21 und eine Konstantstromquelle 22 aufweist, wobei der Summenbildner 21 die Ausgangssignale aus 15 zur Modulation des Konstantstromes von der Quelle 22 verwendet und damit die Stromstärke des Arbeitsstromes der Laserdiode so verändert, daß der Brennfleck oder die Taille des fokussierten Lichtbündels 11 im Spalt 12 gehalten wird, da sich die Frequenz an die momentanen Umweltgegebenheiten und Betriebsparameter anpaßt und dadurch die Wellenlänge konstant gehalten wird. Die Laserdiode 2 ist noch mit einem Peltierkühler 23 versehen. Bereits minimale Positionsänderungen des Brennfleckes ergeben ein starkes Signal. Intensitätsänderungen des Teilstrahles 7 haben nur geringe oder keine Auswirkungen. Verwendet man beim Beugungsgitter 8 ein Material mit sehr geringem Wärmeausdehnungskoeffizienten, dann ergibt sich auch ein temperaturunabhängiger Beugungswinkel. Als praktisches Beispiel sei angegeben, daß die Breite des Spaltes 12 z. B. 5 $\mu$m und der Durchmesser des Brennfleckes 20 $\mu$m betragen kann.

Bei dem nun im Zusammenhang mit Fig. 1 weiter zu beschreibenden Laserinterferometer wird der Arbeitsstrahl 5, der wie schon erwähnt, in einer um 45° geneigten ebene polarisiert ist, in einem polarisierenden Strahlenteilerwürfel 24 in einen weiterführenden Meßstrahl 25 und einen rechtwinkelig abgelenkten Referenzstrahl 26 geteilt. Wegen der Verwendung eines polarisierenden Strahlenteilers sind die beiden Strahlen 25 und 26 in zueinander senkrechten Ebenen polarisiert. Der Strahl 26 trifft nach einer vorgegebenen Referenzstrecke auf einen Trippelreflektor 27 und der Strahl 25 auf einen Trippelreflektor 28, der mit dem beweglichen Teil des Interferometers, z. B. einem Meßschlitten 29, fest verbunden ist und mit diesem verstellt werden kann.

Die an 27 und 28 reflektierten Strahlen werden im Strahlteiler 24 wieder vereint und über einen Spiegel oder ein Reflexionsprisma 30 rechtwinkelig aus dem Strahlengang ausgeblendet. Die beiden ausgeblendeten Teilstrahlen wurden gemeinsam mit 31 bezeichnet. Diese Teilstrahlen sind noch nicht interferenzfähig, da sie unterschiedlich polarisiert sind. Aus diesem Grund werden sie durch eine $\lambda$ /4-Platte geleitet, deren ordentliche und außerordentliche Achse gegenüber den rechtwinkelig zueinander verlaufenden Polarisationsebenen der beiden Teilstrahlen um 45° verdreht ist. Nach Durchtritt der Teilstrahlen 31 durch diese Platte 32 entstehen zwei entgegengesetzt zirkular Polarisierte Wellen, deren resultierende Welle im Teilstrahl 33 linear polarisiert ist, wobei der Vektor der Polarisationsrichtung von der Relativlage des Referenzreflektors 27 zum Meßreflektor 28 abhängt und bei der Verstellung des Meßreflektors in einer von der Verstellrichtung abhängigen Drehrichtung um die Strahlachse dreht. Der Strahl 33 wird nun in einem neutralen Strahlteiler 34 in zwei Teilstrahlen 35, 36 geteilt, die je einem polarisierenden Strahlteilerwürfel 37, 38 zugeleitet werden. Dabei sind diese Strahlteilerwürfel 37, 38 relativ zueinander um 45° geneigt, so daß die vor ihnen abgegebenen geteilten Strahlen 39 in 0°, 40 in 90°, 41 in 45° und 42 in 135° polarisierte Lichtstrahlen sind, deren Intensität von der Drehstellung der Polarisationsrichtung nach der λ/4-Platte 32 abhängt und sich mit deren Drehung ändert, so daß bei der Verstellung des Meßschlittens 29 an Photoempfängern 43, 44, 45, 46 gegeneinander um 90° phasenverschobene sinusförmige Signale auftreten, die einer Auswertungseinheit 47 zugeführt werden, in der durch paarweise Antiparallelschaltung der um 180° versetzten Signale zwei um 90° phasenverschobene Meßsignale erhalten werden, die durch die Antiparallelschaltung von Gleichspannungsanteilen befreit sind und die in weiterer Folge nach bei Inkrementalmeßsystemen bekannten Verfahren in digitale Zählsignale umgewandelt und einer Anzeige- oder Steuereinrichtung 48 zugeführt werden können. Dabei ist nach ebenfalls bekannten Verfahren durch Vervielfacherschaltungen oder Interpolationsrechner einer elektronische Unterteilung und damit eine Vergrößerung des Auflösungsvermögens möglich. Der Einfachheit halber wurde in Fig. 1 je nur eine Linie für den Strahlengang zwischen den Teilen 24, 27, 28, 30 und 32 gezeichnet, obwohl hier jeweils parallele Strahlenzüge (Meßstrahl 25, Referenzstrahl 26, reflektierter Meßstrahl, reflektierter Referenzstrahl) vorhanden sind.

Das Beugungsgitter 8 kann als Echelettegitter ausgebildet sein. Es ist auch möglich, an Stelle des Beugungsgitters 8 und der Optik 10 ein kokav gewölbtes, also fokussierendes Beugungsgitter zu verwenden. Schließlich kann man die reflektierten Strahlen bereits bei dem entsprechend ausgebildeten Strahlteilerwürfel ausblenden, wobei nach einer weiteren Möglichkeit in den Strahlengängen 25, 26 der reflektierten Strahlen schon vor dem Strahlteilerwürfel je eine λ/4-Platte angeordnet wird, die die gemeinsame Platte 32 ersetzt.

**Patentansprüche**

1. Anordnung zur Stabilisierung der Wellenlänge des von einer Laserdiode (2) abgegebenen Arbeitsstrahles (5), insbesondere bei einem Laser-Interferometer, mit einem Regler (20) für den Betriebsstrom der Laserdiode, der von einer auf die momentanen Umweltbedingungen und Betriebsparameter empflindlichen Fühleranordnung (6 - 10, 13 - 15) gesteuert wird, für die in den von der Laserdiode abgegebenen Arbeitsstrahl (5) ein zusätzlicher Strahlteiler (6) eingeschaltet ist, der aus dem Arbeitsstrahl einen Teilstrahl (7) zu einer Meßeinrichtung ausblendet, die vom Teilstrahl über optische Leiteinrichtungen mit sich in Abhängigkeit von der Wellenlänge des Lichtes ändernder Intensität beleuchtete Photoempfänger (13, 14) aufweist, deren Ausgangssignale - gegebenenfalls nach entsprechender Umformung - als Steuersignale für den Regler (20) dienen, dadurch gekennzeichnet, daß die Meßeinrichtung ein Beugungsgitter (8) mit oder ohne Fokussierungsoptik (10) für den ausgeblendeten Teilstrahl (7, 9) aufweist, so daß Lage und/oder Größe eines - gegebenenfalls über die Optik - in einer Empfangsebene erzeugten Lichtfleckes von der momentanen Wellenlänge abhängen, wobei die Photoempfänger (13, 14) Abweichungen des Lichtfleckes aus der der Nenn-Wellenlänge zugeordneten Sollage erfassen.

2. Anordnung nach Anspruch 1, dadurch gekennzeichnet, daß der Lichtfleck bei der Nenn-Wellenlänge auf einen Spalt (12) zwischen zwei Photoempfängern, insbesondere Photodioden (13, 14) fokussiert ist und bei Vergrößerungen der Wellenlänge zu der einen, bei Verringerungen der Wellenlänge zu der anderen Photodiode wandert, so daß das Ausgangssignal der Photoempfänger der momentanen Abweichung entspricht.

3. Anordnung nach den Ansprüchen 1 und 2, dadurch gekennzeichnet, daß das Beugungsgitter (8) als Echelettegitter ausgebildet ist.

4. Anordnung nach einem der Anprüche 1 - 3, dadurch gekennzeichnet, daß das Beugungsgitter (8) als konkaves, selbstfokussierendes Gitter ausgebildet ist.

5. Anordnung nach einem der Ansprüche 1 - 4, dadurch gekennzeichnet, daß für die Versorgung der Laserdiode (2) ein Summierglied (21) vorgesehen ist, an dem eine Konstantstromquelle (22), eine Verstärkerschaltung (15 - 19) und ein Integrierglied (18) für den Strom der Photodioden (13, 14) liegen und das diesen Summenstrom der Laserdiode zuführt.

6. Anordnung nach Anspruch 5, dadurch gekennzeichnet, daß die Verstärkerschaltung (15) ein als Tiefpaß wirkendes Integrierglied (18) enthält.

7. Laserinterferometer, mit einer Laserdiode, die mit einer Anordnung nach einem der Ansprüche 1 - 6 versehen ist, mit einem Strahlteiler (24), der den Arbeitsstrahl (5) des Lasers (2) in einen zu einem festen Reflektor (27) führenden Referenzstrahl (26) und einen zu einem mit dem Meßobjekt (29) verbundenen Meßreflektor (28) führenden Meßstrahl (25) unterteilt, und mit einem Reflektor (30) zur Ausblendung der reflektierten Strahlen (31) zu Photoempfangseinrichtungen (43 - 46), die mit Zähleinrichtungen (47) zur Erfassung der Helligkeitsschwankungen aufgrund bei der Interferenz der Strahlen bei bewegtem Meßreflektor (28) verbunden sind, dadurch gekennzeichnet, daß der Strahlteiler (24) ein polarisierender Strahlteiler ist, wobei die Polarisationsebene des Arbeitsstrahles (5) mit der normal zum Meßstrahl (25) verlaufenden Abstrahlrichtung des Referenzstrahles (26) einen Winkel von 45° einschließt, so daß die Polarisationsebenen von Referenz- und Meßstrahl miteinander einen Winkel von 90° einschließen, daß die polarisierten, reflektierten Strahlen vor oder nach der Ausblendung über wenigstens eine λ /4-Platte (32) mit zu den Polarisationsebenen der beiden Strahlen wieder um 45° verdrehter ordentlicher bzw. außerordentlicher Achse geleitet werden, so daß zwei zirkular polarisierte Wellen entstehen, die zusammengeführt werden und deren resultierende Welle (33) linear polarisiert ist, wobei die Polarisationsrichtung von der Relativlage des Referenzreflektors (27) zum Meßreflektor (28) abhängt und bei der Verstellung des Meßreflektors um die Strahlachse dreht, und daß diese resultierende, linear polarisierte Strahlung (33) in einem neutralen Strahlteiler (34) in zwei Teilstrahlen (35, 36) aufgeteilt wird, die je einem Polarisationsstrahlteiler (37, 38) zugeführt werden, wobei die beiden Polarisationsstrahlteiler Abstrahlrichtungen (39 - 42) für in einer angenommenen 0°-Ebene, einer 90°-Ebene, einer 45°-Ebene und einer 135°-Ebene polarisiertes Licht aufweisen und in diesen Abstrahlrichtungen die Photoempfang seinrichtungen (43 - 46) angeordnet sind und daß - vorzugsweise durch paarweise Zusammenführung der um 180° versetzten Signale der Photoempfänger in Antiparallelschaltung - zwei um 90° gegeneinander phasenverschobene Meßsignalzüge erzeugt werden.

8. Laserinterferometer nach Anspruch 7, dadurch gekennzeichnet, daß eine gemeinsame λ /4-Platte dem Reflektor (30) nachgeordnet, in der die reflektierten Strahlen zusammengeführt werden.

9. Laserinterferometer nach Anspruch 7, dadurch gekennzeichnet, daß der den Arbeitsstrahl teilende Strahlteiler (24) zugleich als der die reflektierten Strahlen ausblendende Reflektor (30) ausgebildet ist und ihm im Strahlengang der reflektierten Strahlen λ /4-Platten für die beiden reflektierten Strahlen vorangestellt sind.

## Claims

1. An arrangement for stabilising the wavelength of the working beam (5) delivered by a laser diode (2), more particularly in a laser interferometer, comprising a controller (20) for the laser diode operating current, which is controlled by a sensor system (6 - 10, 13 - 15), which is sensitive to the instantaneous environmental conditions and operating parameters and for which an additional beam splitter (6) is switched into the working beam (5) delivered by the laser diode, said beam splitter (6) masking out of the working beam a sub-beam (7) to a measuring device which comprises photo-receivers (13, 14) which are illuminated by the sub-beam via optical guide means at an intensity which varies in dependence on the wavelength of the light, and the output signals of which - after appropriate conversion if required - serve as a control signals for the controller (20), characterised in that the measuring device comprises a diffraction grating (8) with or without an optical focusing system (10) for the masked-out sub-beam (7, 9), so that the position and/or the size of a light spot produced in a reception plane - via the optical system where applicable - depend on the instantaneous wavelength, the photo-receivers (13, 14) detecting deviations of the light spot from the set-value position associated with the nominal wavelength.

2. An arrangement according to claim 1, characterised in that the light spot is focused on a gap (12) between two photoreceivers, more particularly photodiodes (13, 14), at the nominal wavelength, and migrates to one photodiode in the event of an increase in wavelength and to the other photodiode in the event of a reduction in wavelength, so that the output signal of the photoreceivers corresponds to the instantaneous deviation.

3. An arrangement according to claims 1 and 2, characterised in that the diffraction grating (6) is constructed as an echelette grating.

4. An arrangement according to any one of claims 1 to 3, characterised in that the diffraction grating (8) is constructed as a concave self-focusing grating.

5. An arrangement according to any one of claims 1 to 4, characterised in that a summation network (21) is provided to supply the laser diode (2) and to it is connected a constant current source (22), an amplifier circuit (15 - 19) and an integrating network (18) for the current for the photodiodes (13, 14) and which feeds this sum current to the laser diode.

6. An arrangement according to claim 5, characterised in that the amplifier circuit (15) contains an integrating network (18) acting as a low-pass.

7. A laser interferometer, comprising a laser diode provided with an arrangement according to any one of claims 1 to 6, comprising a beam splitter (24) which divides the working beam (5) of the laser (2) into a reference beam (26) leading to a fixed reflector (27) and a measuring beam (25) leading to a measuring reflector (28) connected to the object (29) for measurement, and comprising a reflector (30) for masking out the reflected beams (31) to photoreceiver means (43 - 46) which are connected to counting means (47) for detecting the brightness fluctuations due to interference of the beams when the measuring reflector (28) is moved, characterised in that the beam splitter (24) is a polarising beam splitter, the polarisation plane of the working beam (5) included an angle of 45° with the direction of radiation of the reference beam (26), such direction extending normally to the measuring beam (25), so that the polarisation planes of the reference beam and the measuring beam together include an angle of 90°, in that the polarised reflected beams before or after masking out are passed through at least one $\lambda/4$-plate (32) having an extraordinary or ordinary axis turned through 45° in relation to the polarisation planes of the two beams, so that two circularly polarised waves are formed which are combined and the resulting wave (33) of which is linearly polarised, the polarisation direction depending on the position of the reference reflector (27) relative to the measuring reflector (28) and, on movement of the measuring reflector, rotating about the beam axis, and in that this resulting linearly polarised radiation (33) is divided in a neutral beam splitter (34) into two sub-beams (35, 36) each fed to a polarisation beam splitter (37, 38), the two polarisation beam splitters having radiation directions (39 - 42) for light polarised in an assumed 0°-plane, a 90°-plane, a 45°-plane and a 135°-plane and the photoreceiver means (43 - 46) are disposed in these radiation directions and in that two measuring signal trains phase-shifted by 90° relatively to one another are produced - preferably by combining in pairs the 180°-offset signals of the photoreceivers in an anti-parallel circuit.

8. A laser interferometer according to claim 7, characterised in that a common $\lambda/4$-plate is disposed after the reflector (30) and the reflected beams are combined therein.

9. A laser interferometer according to claim 7, characterised in that the beam splitter (24) dividing the working beam is at the same time the reflector (30) which masks out the reflected beams and $\lambda/4$-plates for the two reflected beams precede it in the path of the reflected beams.

**Revendications**

1. Dispositif de stabilisation de la longueur d'onde du rayon de travail (5) émis par une diode laser (2), en particulier pour un interféromètre laser, avec un régulateur (20) destiné au courant de travail de la diode laser et commandé par un dispositif capteur (6 à 10, 13 à 15), sensible aux conditions ambiantes et aux paramètres de fonctionnement instantanés, dispositif pour lequel, dans le rayon de travail (5) émis par la diode laser, est mis en circuit un diviseur (6) de rayon supplémentaire, produisant, à partir du rayon de travail, un rayon partiel (7) allant vers un dispositif de mesure, présentant des photo-récepteurs (13, 14) illuminés par le rayon partiel, par l'intermédiaire de dispositifs directeurs optiques, l'illumination étaant effectuaée avec une intensité variant en fonction de la longueur d'onde de la lumière, photo-récepteurs dont les signaux de sortie servent, le cas échéant, après transformation correspondante, de signaux de commande pour le régulateur (20),
caractérisé en ce que le dispositif de mesure présente un réseau de diffraction (8) avec ou sans optique de focalisation (10) pour le rayon partiel (7, 9) issu de la division, de sorte que la position et/ou la taille d'un point lumineux produit par l'optique dans un plan de réception dépendent de la longueur d'onde instantanée, les photo-récepteurs (13, 14) appréhendant les écarts de position du point lumineux par rapport à une position de consigne associée à la longueur d'onde nominale.

2. Dispositif selon la revendication 1,
caractérisé en ce que le point lumineux est focalisé, pour la longueur d'onde nominale, sur une fente (12) située entre deux photo-récepteurs, en particulier des photo-diodes (13, 14) et qu'en cas d'augmentation de la longueur d'onde, le point lumineux se déplace vers une première photo-diode, et qu'en cas de diminution de la longueur d'onde, il se déplace vers l'autre photo-diode, de sorte que le signal de sortie des photo-récepteurs correspond à l'écart instantané.

3. Dispositif selon les revendications 1 et 2,
caractérisé en ce que le réseau de diffraction (8) est réalisé sous forme de grille échelle.

4. Dispositif selon l'une des revendications 1 et 3,
caractérisé en ce que le réseau de diffraction (8) est réalisé sous forme de grille concave, auto-focalisante.

5. Dispositif selon l'une des revendications 1 à 4,
caractérisé en ce que, pour l'alimentation de la diode laser (2), il est prévu un élément sommateur (21), auquel sont raccordés une source électrique de caractéristique constante (22), un circuit amplificateur (15 à 19) et un élément intégrateur (18) pour l'intensité des photo-diodes (13, 14), et l'élément sommateur (21) délivrant ce courant, une fois intégré, à la diode laser.

6. Dispositif selon la revendication 5,
caractérisé en ce que le circuit amplificateur (15) contient un élément intégrateur (18) à caractéristique passe-bas.

7. Interféromètre laser, avec une diode laser, pourvu d'un dispositif selon l'une des revendications 1 à 6, avec un diviseur de rayon (24) qui subdivise le rayon de travail (5) du laser (2) en un rayon de référence (26) conduisant à un premier réflecteur (27) et en un rayon de mesure (25) conduisant à un réflecteur de mesure (28) relié à l'objet à mesurer (29), et avec un réflecteur (30) destiné à séparer les rayons réfléchis (31) pour les conduire à des dispositifs auto-récepteurs (43 à 46), reliés à des dispositifs compteurs (47) destinés à appréhender les fluctuations de luminosité sur la base de l'interférence des rayons, se produisant lors du déplacement du réflecteur de mesure (28),
caractérisé en ce que le diviseur de rayon (24) est un diviseur de rayon polarisant, le plan de polarisation du rayon de travail (5) faisant, par rapport à la direction de rayonnement s'étendant perpendiculairement par rapport au rayon de mesure (25), du rayon de référence (26), un angle de 45°, de manière que les plans de polarisation des rayons de référence et de mesure fassent l'un par rapport à l'autre un angle de 90°, en ce que les rayons polarisés réfléchis sont dirigés, avant ou après séparation, par au moins une plaque $\lambda/4$ (32), avec un axe ordinaire ou non-ordinaire tourné de nouveau de 45° par rapport aux plans de polarisation des deux rayons, de manière que soient produites deux ondes groupées à polarisation circulaire, et dont l'onde résultante (33) est polarisée linéairement, la direction de polarisation dépendant de la position relative entre le réflecteur de référence (27) et le réflecteur de mesure (28) et tournant autour de l'axe de rayonnement, lors du déplacement du réflecteur de mesure, et en ce que ce rayonnement résultant (33), polarisé linéairement, est subdivisé, dans un diviseur de rayon neutre (34), en deux rayons partiels (35, 36) délivrés chacun à un diviseur de rayon à polarisation (37, 38), les deux diviseurs de rayon à polarisation présentant des directions d'émission (39 à 42) pour de la lumière polarisée dans un plan supposé de 0°, un plan de 90°, un plan de 45° et un plan de 135° et les dispositifs auto-récepteurs (43 à 46) étant disposés dans ces directions d'émission, et en ce que deux trains de signaux de mesure déphasés mutuellement de 90° sont produits, de préférence par groupage par paires des signaux décalés de 180° des photo-récepteurs montés en branchement anti-parallèle.

8. Interféromètre laser selon la revendication 7,
caractérisé en ce qu'une plaque $\lambda/4$ commune, est disposée en aval du réflecteur (30) dans lequel sont groupés les rayons réfléchis.

9. Interféromètre laser selon la revendication 7,
caractérisé en ce que le diviseur de rayon (24), effectuant la division du rayon de travail, est réalisé en même temps sous forme de réflecteur (30) séparant les rayons réfléchis, et que des plaques $\lambda/4$ ,destinées aux deux rayons réfléchis, sont placées dans le trajet des rayons réfléchis.

*FIG.1*

FIG.2

FIG.3

EP 0 564 431 B1